## Europäisches Patentamt
## European Patent Office
## Office européen des brevets

(19)

(11) Publication number: **0 066 053**
**B1**

(12)

# EUROPEAN PATENT SPECIFICATION

(45) Date of publication of patent specification: **17.07.85**

(21) Application number: **82102516.0**

(22) Date of filing: **25.03.82**

(51) Int. Cl.[4]: **H 01 L 21/268,** G 03 F 7/26, G 02 F 2/02, G 02 B 27/00, H 01 S 3/30

(54) Apparatus for, and method of, exposing a photosensitive medium to light.

(30) Priority: **29.05.81 US 268511**

(43) Date of publication of application:
**08.12.82 Bulletin 82/49**

(45) Publication of the grant of the patent:
**17.07.85 Bulletin 85/29**

(84) Designated Contracting States:
**BE CH DE FR GB IT LI NL SE**

(56) References cited:
**WO-A-79/00432**
**CH-A- 504 784**
**GB-A-1 418 299**
**US-A-3 560 258**
**US-A-4 203 078**
**US-A-4 230 994**

**WEBER-HERZINGER"Laser-Grundlagen und Anwendungen", 1972, PHYSIK VERLAG GMBH, Weinheim/Bergstrasse, page 179-185**
**ELEKTRONIK, "Grundlagen der Lasertechnik",Heft 10, 22. Mai 1981, FRANZIS VERLAG GMBH, München, page 97-102**

(73) Proprietor: **International Business Machines Corporation**
**Old Orchard Road**
**Armonk, N.Y. 10504 (US)**

(72) Inventor: **Jain, Kantilal**
**6749 Michele Way**
**San Jose California 95129 (US)**
Inventor: **Willson, Carlton Grant**
**896 Harding Avenue**
**San Jose California 95126 (US)**

(74) Representative: **Hobbs, Francis John**
**IBM United Kingdom Patent Operations Hursley Park**
**Winchester, Hants, SO21 2JN (GB)**

Courier Press, Leamington Spa, England.

## Description

This invention relates to apparatus for exposing a photosensitive medium to light at a plurality of different wavelengths and to a method of exposing a photosensitive medium having a known wavelength sensitivity band.

The drive toward higher density circuitry in microelectronic devices has promoted interest in a variety of high resolution lithographic techniques which require the ability to produce finer resolution patterns at high production rates. In optical lithography, the improvement in resolution that results by use of shorter wavelengths is well known. As a result of these considerations, an effort has been made to develop processes and materials which require exposure in the deep UV spectral region. The light source traditionally used in these prior art systems has been either a deuterium lamp or a xenon-mercury arc lamp. The problem with using such lamps is that insufficient power is available from them in the desired spectral region. For a typical lamp in a typical system, the total deep UV power that can be collected for use is in the few tens of milliwatts range, so that the exposure time for resists that are sensitive in the deep UV are typically several minutes.

It is known that lasers generally produce an intense output, and lasers are known in the prior art which produce outputs in the deep UV spectral region. However, the use of lasers in projection photolithography has traditionally been considered unattractive due to the spatial and temporal coherence characteristics of most lasers.

The invention as claimed seeks to solve the problem of producing a uniform exposure pattern at very fine resolution in an exposure time substantially faster than prior art systems.

According to one aspect of the invention, there is provided an apparatus for exposing a photosensitive medium to light at a plurality of different wavelengths to produce an exposed pattern on the element, the apparatus being characterised by comprising a light source consisting of a pulsed rare gas halide excimer laser.

According to another aspect of the invention, a method of exposing a photosensitive medium having a known wavelength sensitivity band comprising the steps of:

providing a pulsed rare gas halide excimer laser;

selecting an excimer medium for said excimer laser which produces a fundamental output of a predetermined wavelength;

directing the output of the pulsed excimer laser to a Raman cell to produce at least one secondary wavelength within said known wavelength sensitivity band by stimulated Raman scattering in a suitable Raman medium contained in said Ramen cell; and

exposing said photosensitive element to the output of said Raman cell to optimize exposure of the photosensitive element.

Our method and apparatus has the advantage of providing high resolution exposure by a pulsed laser source which has sufficient power to require very short exposure times in the range of a few seconds which, in the deep UV region, represents an improvement by about two orders of magnitude over a conventional mercury lamp.

Another advantage of our method and apparatus is that, in contrast to prior art systems, the excimer laser can be used in both the contact (including proximity) exposure mode and the projection exposure mode (including full-wafer scanning and step-and-repeat systems). The factor that makes the excimer laser usable in these systems without producing speckle is the fact that the mode structure of an excimer laser beam is not a spatially coherent single transverse mode. Instead, the beam is highly multi-mode, and can be thought of as random super-position of a large number of independent Gaussian beams.

A further advantage of our method and apparatus is that the output wavelengths can be shifted as desired by selecting of the excimer and by the stimulated Raman scattering which can be used to produce one or more wavelengths in a desired spectral region. Therefore, the exposure wavelengths can be optimized for the photosensitive medium, rather than the other way around.

How the invention can be carried out will now be described by way of example, with reference to the accompanying drawings, in which:—

Figure 1 is a diagram of a contact or proximity optical lithography system embodying the invention;

Figure 2 is a diagram of a projection optical lithography system embodying the invention;

Figure 3 is a diagram of a step-and-repeat projection optical lithography system embodying the invention;

Figure 4 is a plan view of a photosensitive element exposed by the apparatus of Figure 3;

Figure 5 represents a first embodiment of the light source for the systems of Figures 1, 2 and 3;

Figure 6 represents a second embodiment of the light source for the systems of Figures 1, 2 and 3;

Figure 7 represents a cross-section of a rare gas halide excimer laser light source for the systems of Figures 1, 2, and 3;

Figure 8 represents a cross-section of a Raman cell forming a part of an alternative embodiment of the light source for the systems of Figures 1, 2, and 3;

Figure 9 shows typical potential energy curves for rare gas monohalide molecules and the various states in the operation of an excimer laser;

Figure 10 indicates the image intensity across the beam of the excimer laser shown in Figure 3;

2

Figure 11 is a plot showing the UV spectra of a photosentive material comprising diazonaphthoquinone sensitizer and novolak resin.

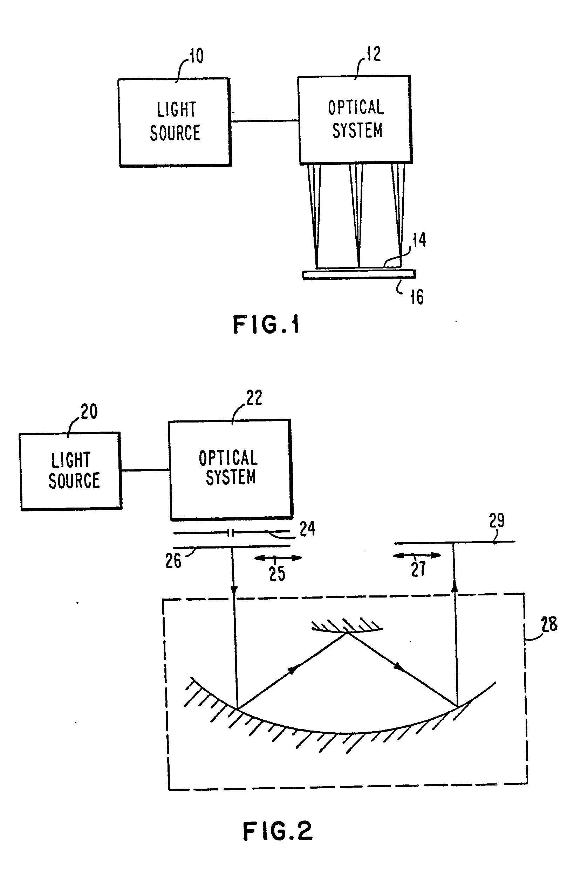

The contact or proximity optical lithography apparatus shown schematically in Figure 1 comprises a suitable light source 10 which produces light of suitable wavelength and intensity and a suitable optical system 12 position to receive the light from source 10, to transform the light to the desired configuration, and to direct the light through a suitable mask member 14 to expose a photosensitive element 16. The optical system 12 includes a condensing element and optical means to direct the beam and to make the beam uniform over the area of mask member 14. The design of such optical systems 12 is well-known in the prior art so the optical system will not be described in any greater detail here. The mask member 14 comprises a pattern of contrast elements (opaque and transparent regions, for example) that define the pattern to be reproduced. Mask member 14 is held either in contact with photosensitive element 16 or is spaced apart in close proximity by a well-controlled gap which is typically a few micrometers. Photosensitive element 16 comprises material which is sensitive to the wavelength of light from light source 10 to produce an image of the mask member pattern where exposed. In a particular embodiment of our invention, photosensitive element 16 comprises a semiconductor wafer on which a thin coating of a photosensitive resist is added. Exposure of the resist and subsequent processing is utilized to produce predetermined patterns by processing the semiconductor wafer to generate desired semiconductor devices.

The projection embodiment of the optical lithography system shown in Figure 2 comprises a suitable light source 20 whose function is to provide light of suitable wavelength and intensity. Optical system 22 functions to receive the light and, utilizing suitable condensing elements and optical elements, to uniformly illuminate the field encompassed by slit exposure member 24. Light from slit exposure member 24 is directed through mask member 26 to projection optical means 28. Projection optical means 28 is designed to direct light from slit exposure member 24 which has passed through mask member 26 to a corresponding point on photosensitive element 29. Mask member 26 and photosensitive element 29 are moved in synchronism (by means not shown) as shown by arrows 25, 27 as the successive areas are exposed. Projection optical means 28, in the embodiment shown, comprises a reflective system, but it will be recognized by those skilled in the art that the projection optical system could as well be a refractive system or a system which includes both reflective and refractive optical elements.

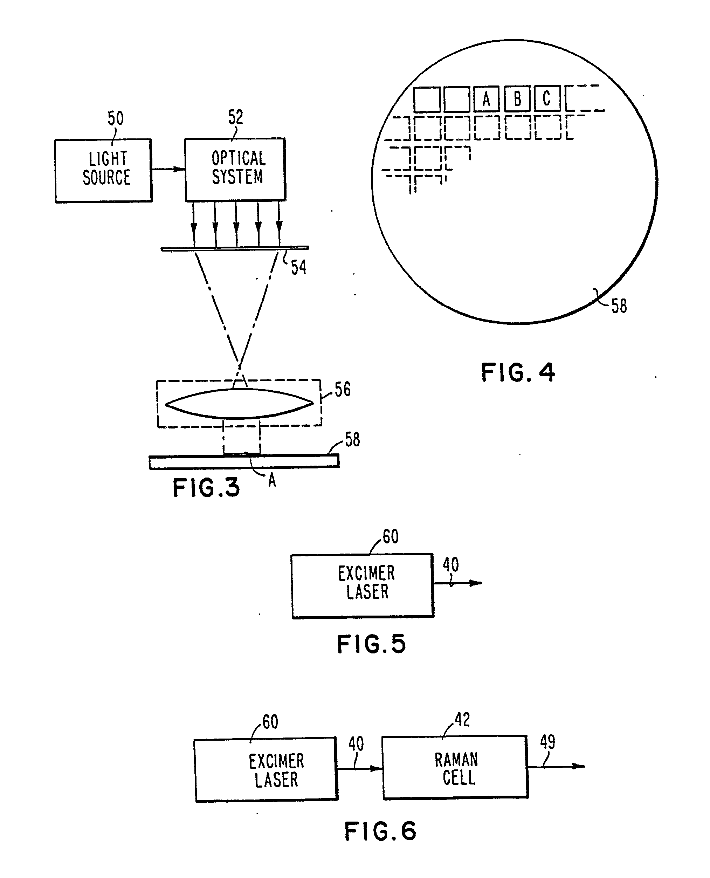

An alternative embodiment of a projection optical lithography system is shown in Figure 3. This system comprises a suitable light source 50 whose function is to provide light of suitable wavelength and intensity. Light from source 50 is directed to optical system 52 which utilizes suitable condensing elements and other optical elements to uniformly illuminate the field encompassed by mask member 54. The design of optical system 52 is well known in the prior art, so this optical system will not be described in any greater detail here. Light from optical system 52 is directed through mask member 54 to projection optical means 56. Projection optical means 56 is designed to produce an image (usually reduced in size) of mask member 54 on photosensitive element 58 in exposure area A. In a specific embodiment, photosensitive element 58 comprises a semiconductor wafer having a thin coating of photosensitive resist. Suitable semiconductor materials include silicon, gallium arsenide, and garnets, such as gadolinium gallium garnet. After exposure of area A, relative motion is produced (by known means, not shown) between mask member 56 and photosensitive element 58 to move another area of element 58 into position for exposure. Succeeding exposures are made to produce exposure areas B, C,... on photosensitive element 58 in a step-and-repeat manner, as shown in Figure 4, to eventually cover the entire element 58.

For projection lithographic systems utilizing refractive optical elements, an excimer laser light source has an additional advantage because of its narrow bandwidth. This factor makes it simpler to correct for chromatic aberrations in the design of refractive optical elements in the projection lithographic systems. This advantage is especially significant for the design of refractive optical elements at short wavelengths where only a limited number of transparent optical materials with differing refractive indices, as required for correction of chromatic abberrations, are available.

According to one embodiment of our invention, the light source 10 in Figure 1, 20 in Figure 2, and 50 in Figure 3, comprises rare gas halide excimer laser means 60 (Figure 5). Rare gas halide excimer lasers are very efficient and powerful pulsed lasers that have only recently become commercially available. These excimer lasers emit several characteristic wavelengths from below 200 nm to above 400 nm, depending on the laser medium, and some of these are listed in Table I.

TABLE I
Representative excimer laser transitions

| Lasing medium | ArF | KrCl | KrF | XeBr | XeCl | XeF |
|---|---|---|---|---|---|---|
| Wavelength (nm) | 193 | 222 | 249 | 282 | 308 | 351 |

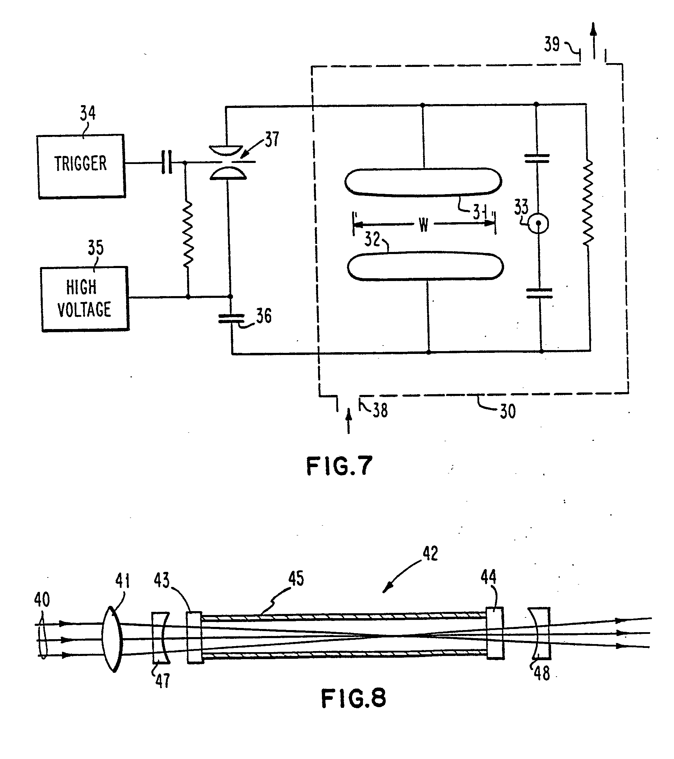

One embodiment of an excimer laser is shown in Figure 7 which comprises a laser chamber 30 defined by a suitable envelope (shown by dashed line in the drawing) which confines a suitable pressurized gaseous lasing medium. This lasing medium may be one of those excimers shown in Table I, and this medium can be selected to provide the desired output wavelength to which the photosensitive element to be used is sensitive. A reservoir (not shown) is normally provided to hold a quantity of the excimer gas. Also provided is a means (not shown) to circulate the gas to gas input pipe 38, maintain the required gas pressure within laser chamber 30, and exhaust the gas at gas outlet pipe 39 for return to the reservoir. Fixed within the laser chamber are spaced-apart main electrodes 31, 32 and a preionizing spark gap 33 which is connected in parallel with the main electrodes. The output from a high voltage source 35 is coupled to charge storage capacitor 36 to a high voltage level. Capacitor 36 is coupled between main electrode 32 and one terminal of spark gap 37. The other terminal of spark gap 37 is connected to main electrode 31. Trigger circuit 34 is utilized to control the operation of the excimer laser by producing a trigger pulse at the time the laser is to be turned ON. The trigger pulse is coupled to the trigger electrode of spark gap 37, and the trigger pulse is of sufficient amplitude to cause breakdown in spark gap 37. The breakdown of spark gap 37 completes the circuit which includes the storage capacitor 36, the main electrodes 31, 32, and the preionizing spark gap 33 in parallel. This causes the gap across the main electrodes and the preionizing gap to break down. The breakdown of the main gap produces emission at the wavelength determined by the selected excimer medium, and the preionizing spark helps to make the emission more uniform.

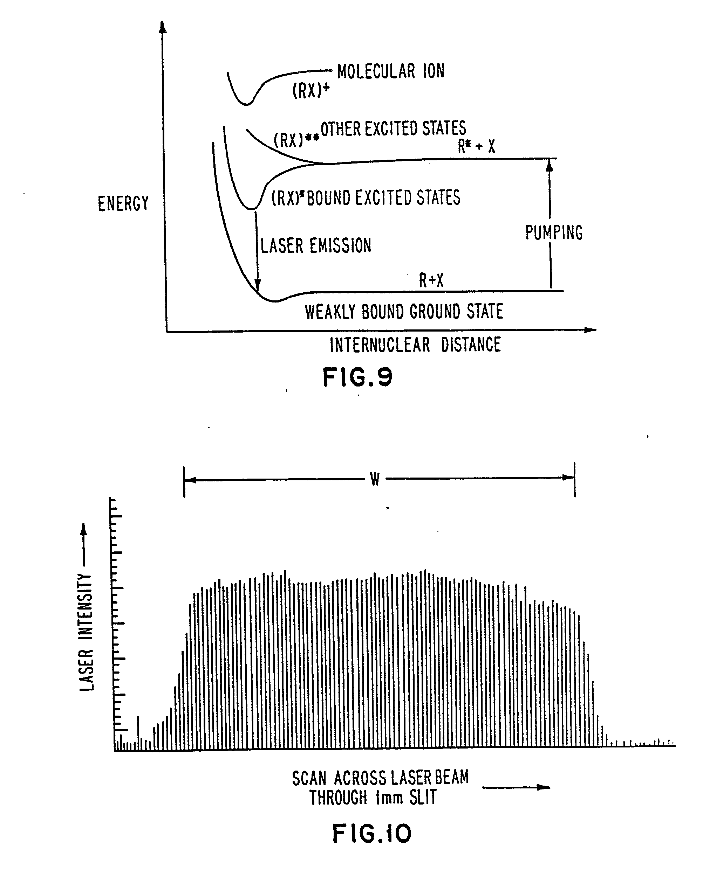

A brief explanation of the operation of the excimer laser light source will now be given in conjunction with the potential energy diagrams shown in Figure 9.

The large family of molecules known as excimers are characterized by a bound excited state and an unstable or very weakly bound ground state. A subset of excimer lasers, known as rare gas halide (RGH) lasers, will be used as an example in explaining the operation of an excimer laser. The RGH lasers lase on transitions of molecules of the type RX, where R and X denote a rare gas atom and a halogen atom, respectively. Typical potential energy curves for an RGH molecule are shown in Figure 9. Population inversion is readily produced because the lower level dissociation time ($\sim 10^{-12}$ sec) is much less than the upper level radiative lifetime ($10^{-9}$—$10^{-6}$ sec). The excitation to the upper state $(RX)^*$ can be produced by several mechanisms. Since the excited state is the same as the ion pair $R^+X^-$, recombination of the positive rare gas ion and the negative halogen ion populates the upper level. The positive and negative ions are readily produced by high-energy electron collisions. Alternatively, an excited rare gas atom $(R^*)$ can directly react with a halogen molecule. Yet another way of producing the upper laser state is a reaction between $R^*$ and a halogen compound, e.g., $NF_3$.

Several different approaches have been used to pump excimer lasers. Four of the most commonly used schemes are: (a) direct excitation by a high-energy electron beam, (b) excitation by an electric discharge which is controlled by an electron beam, (c) direct electric-discharge excitation, and (d) optical pumping. Of these, the direct electric discharge is the most practical in terms of compactness and ease of operation, and this is the embodiment shown in Figure 7. The output beam of width W is in the direction out of the paper, as shown in Figure 7, aligned with the main electrodes.

Excimer lasers can produce an average power of several watts at a number of wavelengths. With discharge-pumped systems, the obtainable pulsewidths are typically $\sim 10$—$100$ ns. Thus, the peak powers are on the order of $\sim 10^7$ W. For systems with average power in the several-watt range, the available repetition rates vary from single pulse to $>1$ kHz. The high brightness of the excimer laser light source can either be used to obtain extremely fast exposures, as was stated above, or one can use significantly smaller numerical apertures (NA) in the projection optical means of the lithographic system and still maintain reasonable exposure times. A smaller NA results in a larger depth of field, which increases quadratically with the inverse of NA. A larger depth of field permits larger tolerances in wafer distortion and focus which leads to better lithographic patterns.

The high power output and the directionality of the excimer laser light source also permits adjustment of the NA of the condenser optics in the lithographic system. This enables one to optimize the modulation transfer function (MTF) of the system and thus produce image patterns with the desired wall profiles in the photoresist. Both of these optimization techniques result in increased device yield in semiconductor integrated circuit fabrication.

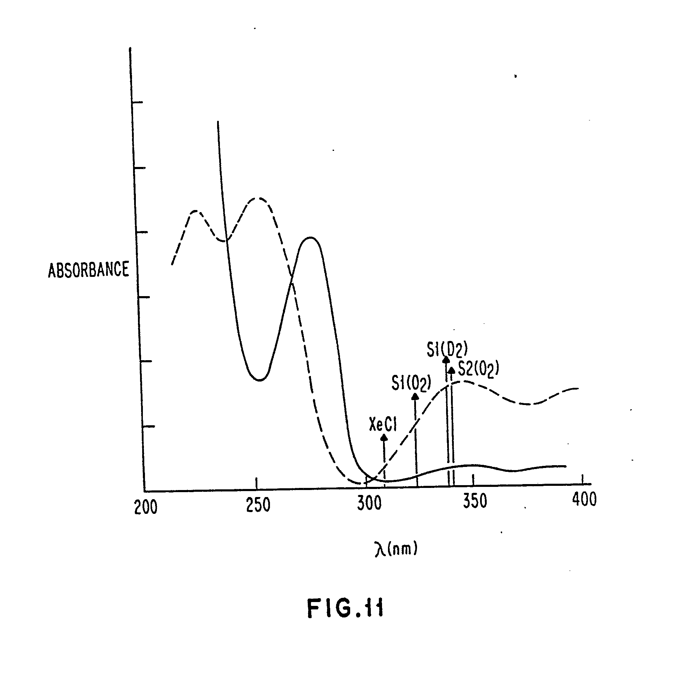

The excimer laser output cross-section depends upon the electrode geometry, and thus can be optimized over a wide range, depending upon the application. Commercial units are available which have various rectangular beam shapes, e.g., 7 mm×20 mm and 25 mm×30 mm. The intensity uniformity across a major portion W of the beam is excellent, as shown in Figure 10. This uniformity arises because the mode structure of these transversely excited beams is extremely non-Gaussian; in fact, it is so highly multi-mode and random that, as was stated above, interference effects due to spatial coherence in a transverse plane were nonexistent in our optical lithography apparatus. The wide, uniform beam of the excimer laser, as contrasted to the extremely narrow and Gaussian (single transverse mode) beam of most other lasers, enables the former system to be used to produce speckle-free patterns in either a contact lithographic system or a projection lithographic system.

The excimer gas selected for use in the excimer laser may comprise only one gas, in which case the output is at the wavelength characteristic of that excimer gas. For example, referring to Table I, the XeCl gas produces an output at 308 nm and this output provides a good match to several photoresists, such as Shipley AZ 2400 (Registered Trade Mark, for example. The KrF gas produces an output at 249 nm which is suitable for exposing photoresists comprising a novolak resin sensitized with a diazo ketone, such as Shipley AZ 2400 and Meldrums diazo photoresists. The KrCl gas produces an output at 222 nm which provides an output appropriate for materials such as the spectral characteristics of poly(methyl methacrylate) (PMMA) and poly(methyl isopropenyl ketone) (PMIPK) photoresists. The selection of two or more gases and the production of a mixture of the selected gases within the laser chamber provide outputs at each of the wavelengths associated with the selected gases.

The use of multiple wavelengths for exposure helps to minimize the often encountered problem of standing waves in the photoresist which result from the interference between the incident exposure radiation and that reflected from the interfaces between the photosensitive medium, the substrate, and the different underlying layers that may be present. The multiple wavelength exposure helps to average any standing waves present so that higher resolution patterns are produced.

To further optimize the exposure, one or more additional wavelengths can be produced by stimulated Raman scattering which can be used to produce one or more wavelength outputs any where within a desired spectral region. One embodiment of a light source which produces a plurality of different wavelength outputs is shown in Figure 6. The light source comprises excimer laser means 60 which produces an output beam 40 having at least one wavelength which is determined by the excimer gas selected for excimer laser means 60. To produce stimulated Raman scattering, the output beam 40 from the excimer laser means 60 (Figure 6) is directed through suitable focusing optical means 41 (Figure 8) to Raman cell 42. At least one secondary wavelength is produced in the output beam 49 from Raman cell 42 which is directed to expose the photosensitive medium. One embodiment of a Raman cell 42 (Figure 8) comprises a tubular member 45 which is closed at each end by a window member 43, 44 to form an enclosure which is filled with a suitable gaseous medium.

The Raman cell utilizes the Raman effect, the inelastic scattering process of photons by excitations in matter. In particular, spontaneous Raman scattering is the process by which the radiation incident on a material experiences a frequency shift due to inelastic scattering from certain characteristic excitations, e.g., molecular vibrations of the medium. When the incident power is made large enough, this frequency-shifted scattered radiation can be stimulated. Whereas the conversion yield in the spontaneous Raman effect is typically $\sim 10^{-7}$, it can be as large as 70% in the stimulated case. Thus, intense coherent light can be produced at different wavelengths by stimulated Raman scattering. The scattered wavelengths can be both up (Stokes)- and down (anti-Stokes)-shifted from the incident laser wavelength by multiples of a molecular vibration (or other elementary excitation) characteristic of the Raman medium. Since very high peak powers are available from excimer lasers, they are ideally suited for stimulated Raman shifting. Thus, each of the wavelengths listed in Table I can be shifted to several new wavelengths by selecting different Raman media. As an example, a wide variety of wavelengths can be produced from the lasers listed in Table I by stimulated Raman scattering in $H_2$, $D_2$, $CH_4$ and liquid nitrogen. A representative group of the wavelengths that can be produced by stimulated Raman scattering is shown in Table II.

### TABLE II
Wavelengths available by various excimer
lasers and stimulated Raman scattering

| | | Wavelength (nm) | | | | | |
|---|---|---|---|---|---|---|---|
| Excimer | Raman medium | Second anti-stokes | First anti-stokes | Primary | First stokes | Second stokes | Third stokes |
| ArF | $H_2$ | 166 | 179 | 193 | 210 | 230 | 254 |
| ArF | $D_2$ | 173 | 182 | 193 | 205 | 218 | 233 |
| KrCl | $H_2$ | 187 | 203 | 222 | 245 | 272 | 307 |
| KrCl | $D_2$ | 196 | 208 | 222 | 238 | 256 | 277 |
| KrF | $H_2$ | 206 | 226 | 249 | 278 | 314 | 361 |
| KrF | $CH_4$ | 217 | 232 | 249 | 268 | 291 | 318 |
| XeCl | $O_2$ | 281 | 294 | 308 | 323 | 341 | 360 |
| XeCl | $D_2$ | 260 | 282 | 308 | 339 | 378 | 426 |

The distribution of the incident laser pulse energy into various modes can be tailored by adjusting the gas pressure within the Raman cell and/or the optics, such as focusing optics 41. To provide additional control over the distribution of power into various modes, dichroic mirrors 47, 48 can be used.

A further variation of the secondary wavelengths available for exposure of a photosensitive element can be produced by including two separate Raman media within the Raman cell. As an example, referring

5

to Table II, the excimer KrCl is selected and both $H_2$ and $D_2$ are included in the Raman cell. In this case, it is possible to get all of the wavelengths listed in Table II for the KrCl excimer and for each of the Raman media $H_2$ and $D_2$, and additional wavelengths due to Raman shifting of the secondary radiation. It can be seen that it is possible to obtain a large number of wavelengths in the output from the Raman cell in this example. The advantages in utilizing multiple wavelengths in producing higher resolution patterns has been discussed above.

To better illustrate the flexibility in operation in an optical lithography system, a specific example wil be given with reference to Figure 11. Shown in Figure 11 are the UV spectra of a photoresist material comprising a diazonaphthoquinone sensitizer (broken line spectrum) and a novolak resin (full line spectrum). This material is ideally suited for exposure by the 365 nm or the 405 nm line of a mercury arc lamp. Referring to Table I, suppose a XeCl laser is available, which produces a fundamental output at 308 nm. Referring to Figure 11, note that the sensitizer does have absorbance at 308 nm, albeit small compared to the absorbance at slightly longer wavelengths. However, due to the much higher power output of the XeCl excimer laser, the latter may be usable alone as an exposure source for this photoresist with reasonable exposure time. But now, consider the improvement possible by stimulated Raman scattering utilizing deuterium as the Raman medium. This operation produces a secondary output at about 340 nm which is near the peak of the sensitizer absorbance. Clearly, this exposure with both the fundamental and one secondary wavelength at almost the peak absorbance would be far superior to an exposure at the much lower power mercury-arc emission line for which the photoresist was designed. As an alternative, a second example is given in Figure 11 of stimulated Raman scattering in which the Raman medium is oxygen ($O_2$). Note that in this case, a first secondary wavelength is produced at about 323 nm and a second secondary wavelength is produced at about 340 nm at almost the peak intensity.

These examples show how the selection of the excimer gas which defines the primary wavelength(s) and the selection of the Raman medium along with other conditions which define the secondary wavelength(s) can be utilized to produce an optimized exposure for a photosensitive medium with known spectral characteristics.

## Claims

1. Apparatus for exposing a photosensitive medium to light at a plurality of different wavelengths to produce an exposed pattern on the element, the apparatus being characterised by comprising a light source consisting of a pulsed rare gas halide excimer laser.

2. Apparatus as claimed in Claim 1, in which the lasing medium in the laser consists of one or more of ArF, KrCl, KrF, XeBr, XeCl and XeF.

3. Apparatus as claimed in any preceding claim, in which the photosensitive element medium consists of novolak resin sensitized with a diazo ketone, or poly(methyl methacrylate), or poly(methyl isopropenyl ketone).

4. Apparatus as claimed in any preceding claim, in which the pulsed rare gas halide excimer laser provides light at a plurality of fundamental wavelengths.

5. Apparatus as claimed in any preceding claim, in which the light source further comprises a Raman cell interposed between the laser and the photosensitive element, the Raman cell producing light at at least one secondary wavelength by stimulated Raman scattering.

6. Apparatus as claimed in Claim 5, in which the Raman cell produces light at a plurality of secondary wavelengths, each corresponding to the or one of the fundamental wavelengths produced by the laser.

7. Apparatus as claimed in Claim 6, in which the Raman cell contains a plurality of different Raman media.

8. Method of exposing a photosensitive medium having a known wavelength sensitivity band comprising the steps of:

providing a pulsed rare gas halide excimer laser;

selecting an excimer medium for said excimer laser which produces a fundamental output of a predetermined wavelength;

directing the output of the pulsed excimer laser to a Raman cell to produce at least one secondary wavelength within said known wavelength sensitivity band by stimulated Raman scattering in a suitable Raman medium contained in said Raman cell; and

exposing said photosensitive element to the output of said Raman cell to optimize exposure of the photosensitive element.

9. Method as claimed in Claim 8, in which the rare gas halide lasing medium is chosen from the group consisting of ArF, KrCl, KrF, XeBr, XeCl and XeF.

10. Method as claimed in Claim 8 or Claim 9, in which the photosensitive medium consists of novolak resin sensitized with a diazo ketone, or poly(methyl methacrylate) or poly(methyl isopropenyl ketone).

## Patentansprüche

1. Apparatus zur Belichtung eines lichtempfindlichen Mediums bei einer Vielzahl von verschiedenen Wellenlaengen zur Abbildung eines Belichtungsmusters auf dem beleuchteten Element, wobei der Apparatus so gekennzeichnet ist, dass er eine Lichtquelle aufweist, die aus einem impulsartigen Excimer-Laser von Edelgas-Halogenid besteht.

2. Apparatus nach Anspruch 1, in dem das strahlende Medium in dem Laser aus einem oder mehreren Element aus der Gruppe von ArF, KrCL, KrF, XeBr, XeCL und XeF besteht.

3. Apparatus nach einem der vorhergehenden Ansprueche, in dem das lichtempfindliche Medium aus einem Novolak-Harz besteht, das wegen Diazoketone oder Poly(Methyl-Methacrylsaureeester) oder Poly(Methyl-Isopropenyl-Ketone) empfindlich ist.

4. Apparatus nach einem der vorhergehenden Ansprueche, in dem der impulsartige Excimer-Laser von Edelgas-Halogenid Licht bei einer Vielzahl von fundamentalen Wellenlaengen erzeugt.

5. Apparatus nach einem der vorhergehenden Ansprueche, in dem die Lichtquelle weiterhin eine Raman-Zelle aufweist, die zwischen dem Laser und dem lichtempfindlichen Element angeordnet ist, wobei diese Raman-Zelle Licht bei mindestens einer sekundaeren Wellenlaenge durch stimulierte Raman-Streuung erzeugt.

6. Apparatus nach Anspruch 5, dadurch gekennzeichnet, dass die Raman-Zelle Licht bei einer Vielzahl von sekundaeren Lichtwellen erzeugt, wobei jede Lichtwelle einer der fundamentalen von dem Laser hergestellten Lichtwelle entspricht.

7. Apparatus nach Anspruch 6, in dem die Raman-Zelle eine Vielzahl von verschiedenen Raman-Medien enthaelt.

8. Verfahren fuer die Belichtung eines lichtempfindlichen Mediums mit einem bekannten Empfindlichkeitsband von Wellenlaengen, wobei das Verfahren folgende Schritte aufweist: Beleuchtung eines impulsartigen Laser aus Edelgas-Halogenid; Auswahl eines Excimer Mediums fuer den Excimer-Laser, der eine fundamentale Leistung von einer vorbestimmten Wellenlaenge erzeugt; Ausrichtung der Leistung des impulsartigen Excimer-Lasers auf einer Raman-Zelle, so dass mindestens eine sekundaere Wellenlaenge in dem bekannten Empfindlichkeitsband durch stimulierte Raman-Streuung in einem geeigneten in der Raman-Zelle vorliegenden Raman-Medium entsteht; und Belichtung des lichtempfindlichen Elements bei der Leistung der Raman-Zelle, um die Belichtung des lichtempfindlichen Elements zu optimizieren.

9. Verfahren nach Anspruch 8, in dem das strahlende Medium aus Edelgas-Halogenid in der Gruppe aus ArF, KrCL, KrF, XeBr, XeCL und XeF ausgewaehlt ist.

10. Verfahren nach Anspruch 8 oder 9, in dem das lichtempfindliche Medium aus einem Novolak-Harz besteht, das wegen Diazoketone oder Poly(Methyl-Methyacrylsaueereester) oder Poly(Methyl-Isopropenyl-Ketone) empfindlich ist.

## Revendications

1. Appareil pour l'exposition à la lumière d'un milieu photosensible sur plusieurs longueurs d'onde différentes afin de produire une configuration exposée sur l'élément, l'appareil étant caractérisé en ce qu'il comprend une source de lumière constituée par un laser excimère pulsé à halogénure de gaz rare.

2. Appareil selon la revendication 1, dans lequel le milieu laser dans le laser est constitué par un ou plusieurs des composés ArF, KrCl, KrF, XeBr, XeCl et XeF.

3. Appareil selon l'une quelconque des revendications précédentes, dans lequel le milieu photosensible est une résine novolak sensibilisée par une diazo-cétone, ou une poly(méthyl méthacrylate), ou poly(méthyl isopropenylcétone).

4. Appareil selon l'une quelconque des revendications précédentes, dans lequel le laser excimère pulsé à halogénure de gaz rare fournit de la lumière sur plusieurs longueurs d'onde fondamentales.

5. Appareil selon l'une quelconque des revendications précédentes, dans lequel le source de lumière comporte, en outre, une cellule de Raman intercalée entre le laser et l'élément photosensible, la cellule de Raman produisant de la lumière sur au moins une longueur d'onde secondaire par diffusion de Raman stimulée.

6. Appareil selon la revendication 5, dans lequel la cellule de Raman produit de la lumière sur plusieurs longueurs d'onde secondaires, chacune correspondant à la longueur d'onde fondamentale ou à l'une des longueurs d'onde fondamentales produite(s) par le laser.

7. Appareil selon la revendication 6, dans lequel la cellule de Raman contient plusieurs milieux de Raman différents.

8. Procédé pour l'exposition d'un milieu photosensible ayant une sensibilité à une bande connue de longueurs d'onde comprenant les étapes qui consistent à:

— fournir un laser excimère pulsé à alongénure de gaz rare;
— sélectionner un milieu excimère pour ledit laser qui produit une sortie fondamentale de longueur d'onde prédéterminée;
— diriger la sortie du laser excimère pulsé sur une cellule de Raman afin de produire au moins une longueur d'onde secondaire dans ladite bande connue de longueurs d'onde par diffusion de Raman stimulée dans un milieu de Raman contenu dans ladite cellule de Raman; et
— exposer ledit élément photosensible à la sortie de la cellule de Raman afin de rendre optimale l'exposition de l'élément photosensible.

9. Procédé selon la revendication 8, dans lequel le milieu laser à halogénure de gaz rare est choisi dans le groupe comprenant ArF, KrCl, KrF, XeBr, XeCl et XeF.

10. Procédé selon la revendication 8 ou la revendication 9, dans lequel le milieu photosensible est une résine novolak sensibilisée par une diazo-cétone ou une poly(méthyl méthacrylate) ou une poly(méthyl isopropenylcétone).

FIG.1

FIG.2

FIG.3

FIG.4

FIG.5

FIG.6

FIG.7

FIG.8

MOLECULAR ION
(RX)⁺

(RX)** OTHER EXCITED STATES

R* + X

ENERGY

(RX)* BOUND EXCITED STATES

PUMPING

LASER EMISSION

R+X

WEAKLY BOUND GROUND STATE

INTERNUCLEAR DISTANCE

**FIG.9**

W

LASER INTENSITY ⟶

SCAN ACROSS LASER BEAM
THROUGH 1mm SLIT ⟶

**FIG.10**

4

FIG.11